# EUROPÄISCHE PATENTANMELDUNG

(11) **EP 3 115 798 A1**
(43) Veröffentlichungstag der Anmeldung: **11.01.2017**
(21) Anmeldenummer: 16177744.6
(22) Anmeldetag: 04.07.2016
(51) Int. Cl.: G01R 31/36, G01R 1/20

(54) **BATTERIESENSOREINHEIT MIT WIDERSTANDSELEMENT**

(30) Priorität: 10.07.2015 DE 102015212959; 29.09.2015 DE 102015218795
(71) Anmelder: Continental Automotive GmbH, 30165 Hannover (DE)
(72) Erfinder: Frenzel, Henryk, 93059 Regensburg (DE); Schramme, Martin, 86343 Königsbrunn (DE)

(57) **Zusammenfassung**

Die Erfindung betrifft eine Batteriesensoreinheit (1) mit einem Widerstandselement (2), insbesondere Mess-Shunt, einer an einen Pol einer Kraftfahrzeugbatterie anschließbaren Befestigungseinrichtung (4), insbesondere einer Polklemme, einem Fahrzeugmasseabgang (5), insbesondere Kabelabgang, und einer Auswerteelektronik,
wobei die Befestigungseinrichtung (4) elektrisch leitend mit dem Widerstandselement (2) und
das Widerstandselement (2) elektrisch leitend mit dem Fahrzeugmasseabgang (5) verbunden ist,
und wobei die Auswerteelektronik dazu ausgebildet ist, an Abgriffstellen eine Spannung über einer Messstrecke, die zumindest das Widerstandselement (2) enthält, zu erfassen, dadurch gekennzeichnet, dass die Messstrecke länger als die Entfernung zwischen den Abgriffstellen ist.

## Beschreibung

Die Erfindung betrifft eine Batteriesensoreinheit gemäß des Oberbegriffs des Anspruchs 1.

Eine derartige Batteriesensoreinheit kommt beispielsweise zum Einsatz um den Zustand einer Fahrzeugbatterie zu überwachen. Es ist bekannt dazu ein Widerstandselement, auch Mess-Shunt, sowohl elektrisch als auch mechanisch zwischen einer Polklemme und einem Fahrzeugmasseabgang zu platzieren. Eine stromdurchflossene Messstrecke wird durch Abgriffstellen auf beiden Seiten des Widerstandselements gebildet. An den Abgriffstellen wird die Spannung gemessen, die über dem Widerstandselement abfällt und daraus die Stromstärke berechnet. Zusätzlich wird die Temperatur der Fahrzeugbatterie erfasst.

Um eine ausreichende Genauigkeit der Messung sicherstellen zu können muss der ohmsche Widerstand des Widerstandselements eine bestimmte Mindestgröße haben. Aus Gründen der Herstellung oder der Konstruktion kann es allerdings vorkommen, dass ein ausreichend hoher Widerstand nicht allein durch die Auswahl des Werkstoffs des Widerstandselements erreicht werden kann. Dies ist beispielsweise der Fall, wenn das Widerstandselement aus dem gleichen Material wie die Polklemme und der Fahrzeugmasseabgang bestehen soll.

Es ist Aufgabe der Erfindung eine Batteriesensoreinheit bereitzustellen, die das genannte Problem löst und dabei sehr robust und/oder kostengünstig und/oder kompakt ist.

Die Aufgabe wird erfindungsgemäß durch eine Batteriesensoreinheit gelöst, deren Messstrecke länger als die Entfernung zwischen den Abgriffstellen ist.

Die gegensätzlichen Auslegungsziele von nahe beieinander liegenden Abgriffstellen und einer langen Messstrecke bzw. eines langen Widerstandselements lassen sich durch diese Maßnahme in Einklang bringen. Einerseits kann durch die nahe beieinander liegenden Abgriffstellen eine kompakte Auswerteelektronik und ein kompaktes Gehäuse realisiert werden, andererseits weist die Messstrecke aufgrund ihrer Länge einen ausreichend hohen ohmschen Widerstand auf, ohne dabei mechanisch instabil zu sein. Dank der großen Länge ist es außerdem nicht mehr nötig einen kleinen Querschnitt zu wählen, um einen geforderten Widerstandswert zu erreichen. Somit erhöht sich auch die thermische Stabilität.

Unter dem Begriff Messstrecke wird vorzugsweise die Strecke verstanden, die der elektrische Strom von einer zur anderen Abgriffstelle zurücklegen muss, bzw. die sich bei mehreren möglichen Stromflusswegen im Mittel ergibt.

Unter Abgriffstellen werden bevorzugt die Schnittstellen zwischen der Auswerteelektronik und dem elektrisch leitfähigen Körper der Batteriesensoreinheit, wenigstens bestehend aus Befestigungseinrichtung, Widerstandselement und Fahrzeugmasseabgang, verstanden.

Vorzugsweise umfasst die Batteriesensoreinheit ein mit der Befestigungseinrichtung elektrisch leitend verbundenes Abzweigeelement. Da die Befestigungseinrichtung über ihre gesamte Ausdehnung im Wesentlichen das gleiche Spannungspotential aufweist, kann über das Abzweigeelement ohne bedeutende Verfälschung von Messungen ein Spannungsabzweig realisiert werden. Das elektrisch leitend mit dem Fahrzeugmasseabgang verbundene Widerstandselement stellt dagegen einen Stromflußzweig für den Laststrom dar. Da das Messen der Spannung bzw. das Erfassen des Stroms aus einer solchen Spannungsmessung über dem gesamten elektrisch leitenden Bereich von dem Abzweigeelement bis zu dem Fahrzeugmasseabgang möglich ist, ergibt sich für die Gestaltung des Widerstandselements ein großer Spielraum. Da das Abzweigeelemenent im Wesentlichen über dessen gesamte Ausdehnung das gleiche Spannungspotential wie die Befestigungseinrichtung aufweist, findet zwischen Befestigungseinrichtung und Abzweigeelement kein Laststromfluss statt. Damit liegt das Abzweigeelement außerhalb der vom Laststrom durchflossenen Strecke. Damit stellt eine Abgriffstelle, welche sich auf dem Abzweigeelement befindet, einen Messpunkt dar, der außerhalb der vom Laststrom durchflossenen Messstrecke liegt.

Beispielsweise umfasst die Batteriesensoreinheit ein mit dem Fahrzeugmasseabgang elektrisch leitend verbundenes Abzweigeelement. Da das Abzweigeelement im Wesentlichen über dessen gesamte Ausdehnung das gleiche Spannungspotential wie eine Stelle aufweist, an der das Abzweigeelement mit dem Fahrzeugmasseabgang verbunden ist, liegt das Abzweigeelement außerhalb der vom Laststrom durchflossenen Strecke. Damit stellt eine Abgriffstelle, welche sich auf dem Abzweigeelement befindet, einen Messpunkt dar, der außerhalb der vom Laststrom durchflossenen Messstrecke liegt.

Der Laststrom ist insbesondere der Strom, der der Batterie von zumindest einem Verbraucher entnommen wird und der der Batterie durch zumindest einen Generator zugeführt wird.

Neben dem Laststrom kann beispielsweise ein deutlich geringerer Leckstrom über die Messstrecke fließen.

Der Leckstrom ergibt sich insbesondere aufgrund der Spannungsmessung. Insbesondere ergibt sich dieser Stromfluss aufgrund eines Spannungsmessgeräts, welches keinen unendlich hohen Innenwiderstand aufweist.

Beispielsweise ergibt sich ein Leckstrom aufgrund eines Übergangswiderstandes zwischen dem Abzweigeelement und der Befestigungseinrichtung bzw. dem Abzweigeelement und dem Fahrzeugmasseabgang.

Beispielsweise können sich aufgrund des Leckstroms Spannungspotentialunterschide über die Ausdehnung der Befestigungseinrichtung oder zwischen dem Abzweigeelement und der Befestigungseinrichtung bzw. dem Fahrzeugmassenabgang bilden.

Liegt eine Abgriffsstelle außerhalb der vom Laststrom durchflossenen Messstrecke, so wird unter dem Begriff Messstrecke vorzugsweise die Strecke verstanden, die der elektrische Laststrom von einem ersten Punkt zu einem zweiten Punkt zurücklegt, bzw. die sich bei mehreren möglichen Stromflusswegen im Mittel ergibt, wobei der erste Punkt im Wesentlichen das Spannungspotential einer der Abgriffstellen aufweist und der zweite Punkt im Wesentlichen das Spannungspotential der anderen Abgriffstelle aufweist.

Vorzugsweise besteht das Abzweigeelement aus dem gleichen Material wie die Befestigungseinrichtung. Dies vereinfacht die Herstellung und reduziert die Kosten.

Besonders bevorzugt wird eine Ausführungsform in der die Abgriffstellen mindestens ein elektrisch leitendes Kontaktelement aufweisen. Dies stellt eine einfache Möglichkeit des Spannungsabgriffs dar und bildet eine Schnittstelle zur Auswerteelektronik.

Der Fahrzeugmasseabgang wird dabei vorzugsweise als das Bauteil bzw. die Bauteile zur elektrisch leitenden Verbindung des Widerstandselements mit Masse verstanden.

Die erfindungsgemäße Batteriesensoreinheit wird dadurch in vorteilhafter Weise weitergebildet, dass die Befestigungseinrichtung und der Fahrzeugmasseabgang aus einem elektrisch leitfähigen Material bestehen, das den Strom besser oder gleich gut leitet wie das Material des Widerstandselements. Dies hält den Widerstand des gesamten Systems und damit auch die Erwärmung bei hohen Strömen klein.

Gemäß einer weiteren vorteilhaften Ausführungsform bestehen die Befestigungseinrichtung, der Fahrzeugmasseabgang und das Widerstandselement aus dem gleichen Material. Die Herstellung wird dadurch einfacher und kostengünstiger.

Die erfindungsgemäße Batteriesensoreinheit wird dadurch in vorteilhafter Weise weitergebildet, dass die Befestigungseinrichtung einen ringförmigen Teilbereich aufweist und das Widerstandselement direkt mit diesem Teilbereich verbunden ist. Dies ist im Sinne einer einfachen Herstellung und kompakten Bauweise sinnvoll.

Vorzugsweise ist das Widerstandselement in einem solchen Winkel mit dem ringförmigen Teilbereich verbunden, der von einer gedachten Linie von der Befestigungsstelle des Abzweigeelements an der Befestigungseinrichtung zu der Mitte des ringförmigen Teilbereichs bemessen wird und der größer als 80° ist. Auf diese Weise ist eine kompakte Anordnung bei großem Gestaltungsspielraum für das Widerstandselement gewährleistet. Vorzugsweise ist das Widerstandselement direkt mit dem Fahrzeugmasseabgang verbunden oder in dieses integriert.

Die erfindungsgemäße Batteriesensoreinheit wird dadurch in vorteilhafter Weise weitergebildet, dass der Fahrzeugmasseabgang mindestens ein Kontaktelement aufweist. Dies stellt eine einfache Möglichkeit des Spannungsabgriffs dar und bildet eine Schnittstelle zur Auswerteelektronik.

Die erfindungsgemäße Batteriesensoreinheit wird dadurch in vorteilhafter Weise weitergebildet, dass die Auswerteelektronik dazu ausgebildet ist, eine Spannung zwischen den Abgriffstellen zu erfassen. Über das ohmsche Gesetz kann daraus auch der Strom berechnet werden.

Die erfindungsgemäße Batteriesensoreinheit wird dadurch in vorteilhafter Weise weitergebildet, dass das Abzweigeelement eine räumliche Ausdehnung in der groben Richtung der Abgriffstelle auf der Seite des Fahrzeugmasseabgangs aufweist. Dies verkürzt den räumlichen Abstand, was eine kompakte Ausführung der Batteriesensoreinheit, insbesondere aber deren Auswerteelektronik, begünstigt.

Die erfindungsgemäße Batteriesensoreinheit wird dadurch in vorteilhafter Weise weitergebildet, dass das Widerstandselement eine gekrümmte Form einnimmt und/oder an mindestens einer Stelle eine Ecke aufweist. Das Widerstandselement gewinnt so an Länge, was zu einem vorteilhaften hohen Widerstandswert führt, bzw. einen größeren Querschnitt des Widerstandselements erlaubt.

Bevorzugt weist die Batteriesensoreinheit ein Elektronikgehäuse auf das die Abgriffstellen umgibt. Dadurch werden die Abgriffstellen vor ihrer Umgebung geschützt.

Vorzugsweise liegt zumindest ein Teil des Widerstandselements außerhalb des Elektronikgehäuses. Somit kann das Elektronikgehäuse kompakt ausfallen bzw. das Widerstandselement sehr lang ausgeführt werden. Außerdem kann das Widerstandselement durch Umgebungsluft gekühlt werden.

Gemäß einer weiteren vorteilhaften Ausführungsform der erfindungsgemäßen Batteriesensoreinheit hat das Widerstandselement einen rechteckigen Querschnitt. Auf diese Weise ist eine zielgerichtete Anpassung des Widerstandselements an erwartbare Belastungen ohne deutlich erhöhte Herstellungskosten möglich.

Die erfindungsgemäße Batteriesensoreinheit wird dadurch in vorteilhafter Weise weitergebildet, dass der rechteckige Querschnitt des Widerstandselements ein Seitenverhältnis aufweist, das größer als 0,2 ist. Damit ist eine sinnvolle Verformungs- und Bruchfestigkeit gewährleistet.

Vorzugsweise ist das Widerstandselement in die Befestigungseinrichtung integriert oder umgekehrt. Dies verringert die Herstellungskosten.

Vorzugsweise ist das Abzweigeelement in die Befestigungseinrichtung integriert oder umgekehrt. Dies verringert die Herstellungskosten.

Vorzugsweise ist das Abzweigeelement so ausgeführt, dass es den Fahrzeugmasseabgang mechanisch unterstützt. Dabei sind beide vorzugsweise elektrisch nicht leitend miteinander verbunden.

Die Erfindung wird nachfolgend anhand mehrerer Ausführungsbeispiele und Zeichnungen näher beschrieben. Es zeigt in schematischer Darstellung
Fig. 1 eine erfindungsgemäße Batteriesensoreinheit gemäß einem ersten Ausführungsbeispiel.
Fig. 2 eine erfindungsgemäße Batteriesensoreinheit gemäß einem zweiten Ausführungsbeispiel in einer Draufsicht.
Fig. 3 eine erfindungsgemäße Batteriesensoreinheit gemäß des Ausführungsbeispiels der Figur 2 in einer räumlichen Ansicht.

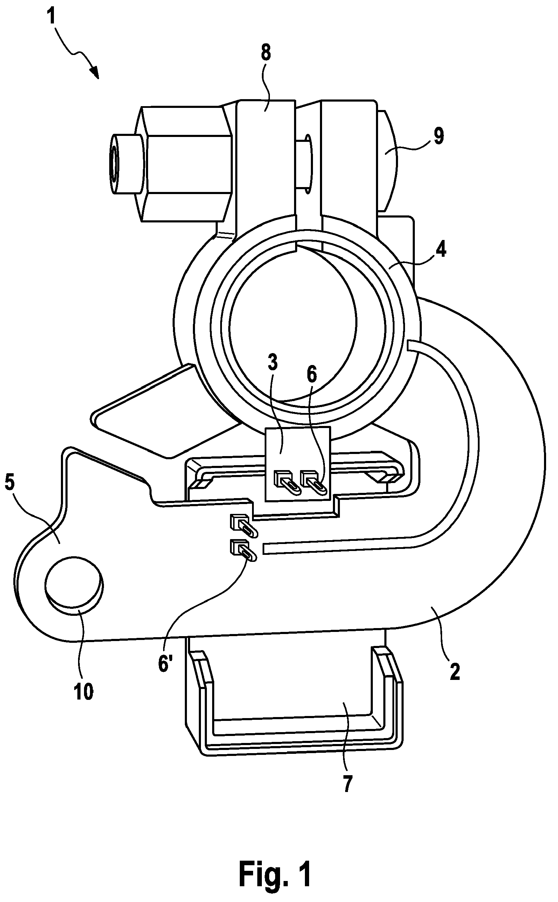

Die in Fig. 1 gezeigte Batteriesensoreinheit weist ein Widerstandselement 2, ein Abzweigeelement 3, eine Befestigungseinrichtung 4, einen Fahrzeugmasseabgang 5 sowie eine nicht dargestellte Auswerteelektronik auf.

Die Batteriesensoreinheit 1 ist an eine nicht gezeigte Batterie eines Kraftfahrzeugs angeschlossen, um in erster Linie den Strom bzw. die Spannung der Batterie zu erfassen. In zweiter Linie ist auch eine Erfassung der Temperatur möglich. Der Anschluss an die Batterie erfolgt über die Befestigungseinrichtung 4 in Form einer Polklemme, welche zu diesem Zweck mit einem hülsenartigen, ringförmigen Teilbereich mit einer Innenkontur ausgeformt ist, der zum Pol einer Batterie passt. Um einen festen Anschluss an den Pol zu gewährleisten, ist die Befestigungseinrichtung 4 so ausgebildet, dass sie mit Hilfe der Klemmschraube 9 angezogen werden kann. Dabei werden zwei Schenkel 8 der Befestigungseinrichtung 4 mit Hilfe des Gewindes der Klemmschraube 9 zusammengezogen, was dazu führt, dass die Innenkontur der Befestigungseinrichtung 4 fest am Pol der Batterie anliegt. Die Befestigungseinrichtung 4 besteht in diesem Ausführungsbeispiel aus einem kupferhaltigen elektrisch leitenden Material. Weitere Bestandteile des Materials könnten beispielsweise Eisen, Phosphor und/oder Zink sein.

An der Außenseite des ringförmigen Teilbereichs der Befestigungseinrichtung 4 ist das Abzweigeelement 3 in die Befestigungseinrichtung 4 integriert. Eine Schweiß- oder Steckverbindung wäre, ebenso wie eine Löt- , Schraub- , Niet- oder Clinchverbindung, jedoch ebenfalls denkbar. Das Abzweigeelement 3 weist im Wesentlichen über dessen gesamte Ausdehnung das gleiche Spannungspotential wie die Befestigungseinrichtung 4 auf. Daher fließt zwischen Befestigungseinrichtung 4 und Abzweigeelement 3 kein Laststrom. Zum Messen einer Spannung umfasst die Batteriesensoreinheit 1 Abgriffstellen, die durch die Kontaktelemente 6, 6' gebildet werden. Das Abzweigeelement 3 ist so ausgeführt, dass dessen Kontaktelemente 6 nahe bei den Kontaktelementen 6' am anderen Ende des Messbereichs liegen. Es sei angemerkt, dass die Abgriffstellen auch anders als durch die Kontaktelemente 6, 6' ausgebildet sein können. Der Begriff der Kontaktelemente 6, 6' ist daher in den Ansprüchen und der Beschreibung im Sinn von Abgriffstellen zu verstehen und mit diesem Begriff austauschbar.

Der Messbereich wird durch das Widerstandselement 2 elektrisch leitend geschlossen. Es ist in integrierter Form mit der Befestigungseinrichtung 4 verbunden. Eine Elektronenstrahl-, Laser- oder Punktschweißverbindung, wie auch weitere stoffschlüssige Verbindungsarten wären jedoch ebenfalls denkbar.

Dank des grob in Richtung des Fahrzeugmasseabgangs 5 bzw. den darauf positionierten Kontaktelementen 6' ausgerichteten Abzweigeelements 3 ist es möglich, dass die Kontaktelemente 6 des Abzweigeelements 3 und die Kontaktelemente 6' des Fahrzeugmasseabgangs 5 räumlich nahe beieinander liegen. Der Weg des elektrischen Stromes, insbesondere durch das Widerstandselement 2 ist dagegen deutlich länger.

Dies ist vor allem deshalb vorteilhaft, weil der elektrische Widerstand des Widerstandselements 2 eine bestimmte Mindestgröße haben muss, um eine ausreichende Messgenauigkeit zu gewährleisten. Der elektrische Widerstand ist hierbei proportional zu der Länge, bzw. der Wegstrecke in Stromrichtung entlang des Widerstandselementes 2. Gleichzeitig ist der elektrische Widerstand reziprok proportional zur Querschnittsfläche des Widerstandselementes 2, also der Fläche senkrecht zur Stromrichtung. Daraus ergibt sich zunächst, dass die Querschnittsfläche zum Erreichen der Mindestgröße des elektrischen Widerstands möglichst klein sein sollte. Da jedoch das Abzweigeelement 3 und nicht beispielsweise das Widerstandselement 2 die Kontaktelemente 6 für den Spannungsabgriff durch die nicht dargestellte Auswerteelektronik bereitstellt, ist das Widerstandselement 2 relativ lang ausgeführt. Durch die große Länge wird ein relativ großer Querschnitt des Widerstandselements 2 kompensiert, so dass die Mindestgröße des Widerstands erreicht werden kann. Der große Querschnitt hat dabei den Vorteil, dass er den gesamten Widerstandsbereich unempfindlich gegen Erwärmung bei hohen Strömen macht. Der Widerstandsbereich ist dabei als der Bereich definiert, der ausgehend von den Kontaktelementen 6 des Abzweigeelements 3 zu den Kontaktelementen 6' des Fahrzeugmasseabgangs 5 von Strom durchflossen wird. Die Form des Widerstandselements 2 in Stromrichtung folgt dem Ziel einer kompakten und robusten Ausführung der Batteriesensoreinheit 1.

An das Widerstandselement 2 schließt sich der Fahrzeugmasseabgang 5 an, der die Kontaktelemente 6' enthält, so dass über dem Widerstandsbereich eine Spannung abgegriffen, bzw. ein Strom ermittelt werden kann, wobei über das ohmsche Gesetz die jeweils andere Größe ermittelt werden kann. Die dafür genutzte Auswerteelektronik wird von einem Elektronikgehäuse 7 geschützt. Der Fahrzeugmasseabgang 5 weist eine Kabelöffnung 10 auf. Hier liegt die Verbindung zur Masse, beispielsweise dem Chassis des Fahrzeugs, über ein nicht dargestelltes beispielsweise anschraubbares Kabel vor. Das Kabel wird dabei an einen bolzenartigen Abgangspol, der hier nicht dargestellt ist, angeschraubt oder andersartig, beispielsweise über einen an der Kabelöffnung 10 befestigten Kabelschuh befestigt.

Der Laststrom zwischen der Befestigungseinrichtung 4 und dem Fahrzeugmasseabgang 5 fließt über das Widerstandselement 2. Damit liegt das Abzweigeelement 3 außerhalb der vom Laststrom durchflossenen Strecke, insbesondere außerhalb der Messstrecke. Folglich liegt auch die Abgriffstelle des Abzweigeelements, bzw. das Kontaktelement 6 außerhalb der vom Laststrom durchflossenen Messstrecke.

Mit dem geschilderten Aufbau wird eine elektrische Verbindung von einem Pol der Batterie zur Fahrzeugmasse erzeugt, die über die Kontaktelemente 6, 6' eine präzise Erfassung des Batteriestromes ermöglicht.

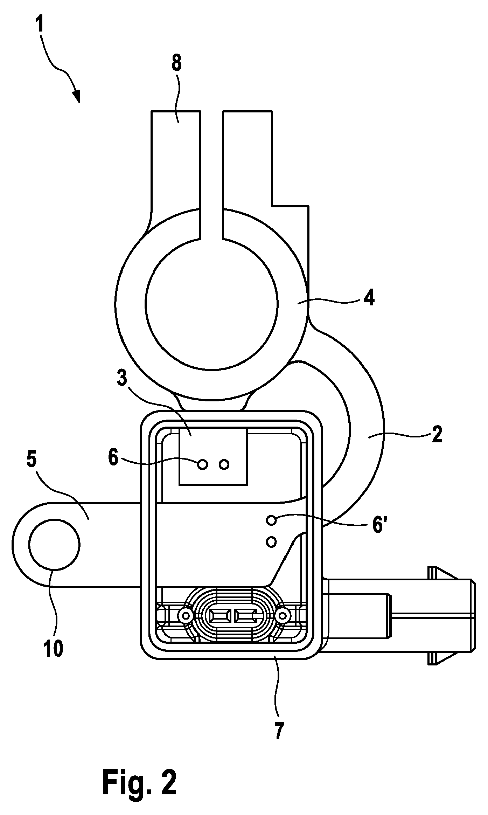

In Fig. 2 ist ein zweites Ausführungsbeispiel einer erfindungsgemäßen Batteriesensoreinheit gezeigt. Auf eine wiederholte Beschreibung identischer Merkmale der vorausgehenden Figur wird verzichtet. Der Fahrzeugmasseabgang 5 ist hier in integrierter Form mit dem Widerstandselement 2 verbunden und wird teilweise durch das Elektronikgehäuse 7 eingekapselt, welches wie schon beim ersten Ausführungsbeispiel aufgeschnitten dargestellt ist.

Das Kontaktelement 6' befindet sich im Bereich des Übergangs vom Widerstandselement 2 zum Fahrzeugmasseabgang 5 und hat damit eine geringe Entfernung zu dem Kontaktelement 6. Beide werden durch das Gehäuse eingekapselt.

Das Widerstandselement 2 ist bogenförmig ausgebildet und hat einen Querschnitt, der etwas kleiner ausfällt als der des Fahrzeugmasseabgangs 5.

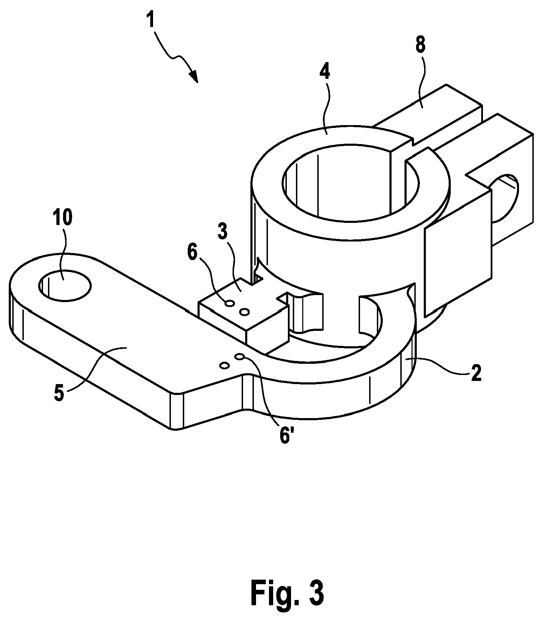

Fig. 3 zeigt das Ausführungsbeispiel der Figur 2 in einer räumlichen Ansicht ohne das Elektronikgehäuse. Auf eine wiederholte Beschreibung identischer Merkmale der vorausgehenden Figur wird verzichtet.

## Patentansprüche

1. Batteriesensoreinheit (1) mit
- einem Widerstandselement (2), insbesondere Mess-Shunt,
- einer an einen Pol einer Kraftfahrzeugbatterie anschließbaren Befestigungseinrichtung (4), insbesondere einer Polklemme,
- einem Fahrzeugmasseabgang (5), insbesondere Kabelabgang, und
- einer Auswerteelektronik,
wobei die Befestigungseinrichtung (4) elektrisch leitend mit dem Widerstandselement (2) und
das Widerstandselement (2) elektrisch leitend mit dem Fahrzeugmasseabgang (5) verbunden ist,
und wobei die Auswerteelektronik dazu ausgebildet ist, an Abgriffstellen eine Spannung aufgrund eines Laststroms über einer Messstrecke, die zumindest das Widerstandselement (2) enthält, zu erfassen,
**dadurch gekennzeichnet, dass** die Messstrecke länger als die Entfernung zwischen den Abgriffstellen ist, wobei mindestens eine Abgriffstelle außerhalb der vom Laststrom durchflossenen Messstrecke liegt.

2. Batteriesensoreinheit (1) nach Anspruch 1, umfassend ein mit der Befestigungseinrichtung (4) elektrisch leitend verbundenes Abzweigeelement (3).

3. Batteriesensoreinheit (1) nach Anspruch 2, wobei das Abzweigeelement (3) aus dem gleichen Material besteht wie die Befestigungseinrichtung (4).

4. Batteriesensoreinheit (1) nach einem der vorhergehenden Ansprüche, wobei die Abgriffstellen jeweils mindestens ein elektrisch leitendes Kontaktelement (6) aufweisen.

5. Batteriesensoreinheit (1) nach einem der vorhergehenden Ansprüche, wobei die Befestigungseinrichtung (4) und der Fahrzeugmasseabgang (5) aus einem elektrisch leitfähigen Material bestehen, das den Strom besser oder gleich gut leitet wie das Material des Widerstandselements (2).

6. Batteriesensoreinheit (1) nach einem der vorhergehenden Ansprüche, wobei die Befestigungseinrichtung (4), der Fahrzeugmasseabgang (5) und das Widerstandselement (2) aus dem gleichen Material bestehen.

7. Batteriesensoreinheit (1) nach einem der vorhergehenden Ansprüche, wobei die Befestigungseinrichtung (4) einen ringförmigen Teilbereich aufweist und das Widerstandselement (2) direkt mit diesem Teilbereich verbunden ist.

8. Batteriesensoreinheit (1) nach Anspruch 2 oder 3 und Anspruch 7, wobei das Widerstandselement (2) in einem solchen Winkel mit dem ringförmigen Teilbereich verbunden ist, der von einer gedachten Linie von der Befestigungsstelle des Abzweigeelements (3) an der Befestigungseinrichtung (4) zu der Mitte des ringförmigen Teilbereichs bemessen wird und der größer als 80° ist.

9. Batteriesensoreinheit (1) nach einem der vorhergehenden Ansprüche, wobei das Widerstandselement (2) direkt mit dem Fahrzeugmasseabgang (5) verbunden oder in dieses integriert ist.

10. Batteriesensoreinheit (1) nach einem der vorhergehenden Ansprüche, wobei der Fahrzeugmasseabgang (5) mindestens ein Kontaktelement (6') aufweist.

11. Batteriesensoreinheit (1) nach einem der vorhergehenden Ansprüche, wobei die Auswerteelektronik dazu ausgebildet ist, eine Spannung zwischen den Abgriffstellen zu erfassen.

12. Batteriesensoreinheit (1) nach Anspruch 2 oder 3, wobei das Abzweigeelement (3) eine räumliche Ausdehnung in der groben Richtung der Abgriffstelle auf der Seite des Fahrzeugmasseabgangs (5) aufweist.

13. Batteriesensoreinheit (1) nach einem der vorhergehenden Ansprüche, wobei das Widerstandselement (2) eine gekrümmte Form einnimmt und/oder an mindestens einer Stelle eine Ecke aufweist.

14. Batteriesensoreinheit (1) nach einem der vorhergehenden Ansprüche, aufweisend ein Elektronikgehäuse (7) das die Abgriffstellen umgibt.

15. Batteriesensoreinheit (1) nach Anspruch 14, wobei zumindest ein Teil des Widerstandselements (2) außerhalb des Elektronikgehäuses (7) liegt.
